# EUROPEAN PATENT APPLICATION

(11) **EP 4 099 383 A1**
(43) Date of publication of application: **07.12.2022**
(21) Application number: 22176372.5
(22) Date of filing: 31.05.2022
(51) Int. Cl.: H01L 23/552, H01L 21/50, H01L 23/047, H01L 23/10, H01L 23/495, H01L 23/498, H01L 23/00

(54) **FARADAY CAGE PLASTIC CAVITY PACKAGE WITH PRE-MOLDED CAVITY LEADFRAME**

(30) Priority: 31.05.2021 US 202163195082 P
(71) Applicant: Ubotic Company Limited, Tsuen Wan (HK)
(72) Inventor: TAM, Ming-Wa, Twuen Wan (HK); KWAN, Kenneth, Kwai Chung (HK)
(74) Representative: Studio Torta S.p.A.

(57) **Abstract**

A Faraday cage cavity package, having: a leadframe; a plastic body molded onto the leadframe to form a cavity exposing top surfaces of a die attach paddle, tie bars and lead fingers of the leadframe within the cavity; and a lid attached onto the top of the leadframe to protect a die attached to the die attach pad from electromagnetic fields, wherein the Faraday cage cavity package is manufactured in a matrix format and then separated into a plurality of individual Faraday cage cavity package units.

## Description

### RELATED APPLICATION

The present application claims priority to United States provisional patent application Ser, No. 63/195082, of same title, filed May 31, 2021, the entire disclosure of which is incorporated herein by reference in its entirety for all purposes.

### FIELD OF INVENTION

The present invention relates generally to integrated circuits, and more particularly to a Faraday cage plastic cavity package with a pre-molded cavity leadframe.

### BACKGROUND

Flat no-leads packages such as QFN (quad-flat no-leads) and DFN (dual-flat no-leads) are used to physically and electrically connect integrated circuits to printed circuit boards. Two types of flat no-leads packages are common: cavity (i.e. with a cavity designed into the package containing air or nitrogen), and plastic-molded (i.e. with minimal air in the package). The cavity package is usually made up of three parts; a copper leadframe, plastic-molded body (open, and not sealed), and a cap or lid attached to the plastic portion of the leadframe. An integrated circuit (IC) is mounted to a die attach pad within the cavity, with wire leads connecting the IC to the leadframe. The leadframe terminates in contacts on the bottom of the package for providing electrical interconnection with a printed circuit board.

Cavity packages are small and lightweight, with good thermal and electrical performance that makes them suitable for portable communication / consumer products. Applications include cellular phones, PDAs, wireless transmitters, RF front end, HD devices, microcontrollers, pre-amplifiers, servers, smart power suppliers, switches, DSPs, ASICs and wrist watches.

US Patents 9,257,370 and 9,536,812, the contents of which are incorporated herein by reference, both disclose a metal ring that is integrated into the pre-molded cavity leadframe. The metal ring provides an electrical ground path from the metal cap to the die attach pad and permits attachment of the metal cap to the pre-molded leadframe using solder reflow onto. These patents both disclose traditional cavity packages with pre-molded leadframes useful for protecting sensitive integrated circuit dies from hazardous environments. These cavity packages with pre-molded leadframes also provide a format for such dies to be easily handled and directly attached onto external circuits such as printed circuit boards.

What is now desired, however, is a convenient Faraday cage for an integrated circuit die that would also protect the integrated circuit die from interference from external electromagnetic fields. As will be shown, the present system provides such a solution using molded leadframe technology.

### SUMMARY

According to an aspect of the invention, a Faraday cage plastic cavity package with a pre-molded cavity leadframe is provided, as set forth in the specification below and the attached drawings.

In preferred embodiments, the present system provides a Faraday cage cavity package, comprising: (a) a leadframe having a die attach paddle, tie bars extending outwardly from the die attach paddle, and lead fingers positioned between the tie bars; (b) a body molded to the leadframe forming a cavity exposing top surfaces of the die attach paddle, the tie bars and the lead fingers within the cavity; (c) a die attached to the die attach pad by wire bonding to the lead fingers; and (d) a lid attached onto the top of the leadframe, the lid having an electrically conductive portion in electrical contact with the tie bars.

In optional embodiments, connecting leads may be attached onto the tie bars, and the plastic molding does not cover these connecting leads. These connecting leads may be connecting leads solder balls connected by solder reflow. In other optional embodiments, the molding may be performed such that there are additional cavities over the distal ends of the tie bars, and these additional cavities can be filled with conductive materials. In further optional embodiments, the tie bars may have design pads formed thereon (within the cavity) and be in contact with an electrically conductive coating on the bottom end portions of the lid. In optional embodiments, the lid may be a metal lid, or a plastic lid with an electrically conductive coating. To assist in mounting the bottom of the present Faraday cage cavity package to a printed circuit board, portions of the bottom surfaces of the die attach paddle and the lead fingers may be plated for surface mount reflow, while other portions may be oxidized to resist solder wetting.

The present system can advantageously be used in a variety of different preferred methods. In accordance with one preferred method, a system for manufacturing a Faraday cage cavity package is provided, comprising: (a) fabricating a matrix of leadframes, each leadframe in the matrix having: a die attach paddle, tie bars extending outwardly from the die attach paddle, and lead fingers positioned between the tie bars; (b) molding plastic onto the matrix of leadframes, wherein the molding the plastic comprises forming a cavity in each leadframe exposing portions of top surfaces of the die attach paddle, the tie bars and the lead fingers within the cavity; (c) attaching a die to the die attach paddle on each leadframe by wire bonding the die to the lead fingers; (d) attaching a lid onto the top of each leadframe, the lid having an electrically conductive portion in electrical contact with the tie bars; and then (e) separating the matrix of leadframes into a plurality of individual Faraday cage cavity package units.

In different aspects of this preferred method, connecting leads (for example, solder balls) may be attached onto the tie bars prior to molding the plastic onto the matrix of leadframes, or additional cavities may be formed at the distal ends of the tie bars and then filled with conductive materials, or the tie bars may have design pads thereon which are then connected to the lid. The lid may be a metal lid or a plastic lid with electrically conductive coatings thereon. Bottom surfaces of the die attach paddle and the lead fingers may be soldered to an external circuit such as a printed circuit board.

In preferred aspects, the present Faraday cage cavity packages are manufactured in a matrix format, and then are then separated into a plurality of individual Faraday cage cavity package units by saw singulation.

### BRIEF DESCRIPTION OF THE DRAWINGS

Features and advantages of the invention will be apparent from the detailed description which follows, taken in conjunction with the accompanying drawings, which together illustrate, by way of example, features of the invention; and, wherein:
FIG. 1A is a top perspective view of a prior art cavity package with a pre-molded cavity leadframe with a lid thereon as illustrated in US Patents 9,257,370 and 9,536,812.
FIG. 1B is a bottom perspective view of the prior art device of FIG. 1A.
FIG. 1C is a top perspective view of the prior art device of FIGS. 1A and 1B with the lid removed, showing further details of the device.
FIG. 2 is flowchart showing steps in a process for constructing a Faraday cage plastic cavity package with a pre-molded cavity leadframe, according to a first exemplary embodiment.
FIG. 3 shows details of a first step of the process set forth in FIG. 2.
FIG. 4 shows details of a second step of the process set forth in FIG. 2.
FIG. 5 shows details of a third step of the process set forth in FIG. 2.
FIG. 6 shows details of a fourth step of the process set forth in FIG. 2.
FIG. 7 shows details of a fifth step of the process set forth in FIG. 2.
FIG. 8 shows details of a sixth step of the process set forth in FIG. 2.
FIG. 9 is flowchart showing steps in a process for constructing a Faraday cage plastic cavity package with a pre-molded cavity leadframe, according to a second exemplary embodiment.
FIG. 10 shows details of a first step of the process set forth in FIG. 9.
FIG. 11 shows details of a second step of the process set forth in FIG. 9.
FIG. 12 shows details of a third step of the process set forth in FIG. 9.
FIG. 13 shows details of a fourth step of the process set forth in FIG. 9.
FIG. 14 shows details of a fifth step of the process set forth in FIG. 10.
FIG. 15 shows details of a sixth step of the process set forth in FIG. 11.
FIG. 16 is flowchart showing steps in a process for constructing a Faraday cage plastic cavity package with a pre-molded cavity leadframe, according to a third exemplary embodiment.
FIG. 17 shows details of a first step of the process set forth in FIG. 16.
FIG. 18 shows details of a second step of the process set forth in FIG. 16.
FIG. 19 shows details of a third step of the process set forth in FIG. 16.
FIG. 20 shows details of a fourth step of the process set forth in FIG. 16.
FIG. 21 shows details of a fifth step of the process set forth in FIG. 16.

Reference will now be made to the exemplary embodiments illustrated, and specific language will be used herein to describe the same. It will nevertheless be understood that no limitation of the scope of the invention is thereby intended.

### DETAILED DESCRIPTION OF EXAMPLE EMBODIMENTS

Before the present invention is disclosed and described, it is to be understood that this invention is not limited to the particular structures, process steps, or materials disclosed herein, but is extended to equivalents thereof as would be recognized by those ordinarily skilled in the relevant arts. It should also be understood that terminology employed herein is used for the purpose of describing particular embodiments only and is not intended to be limiting.

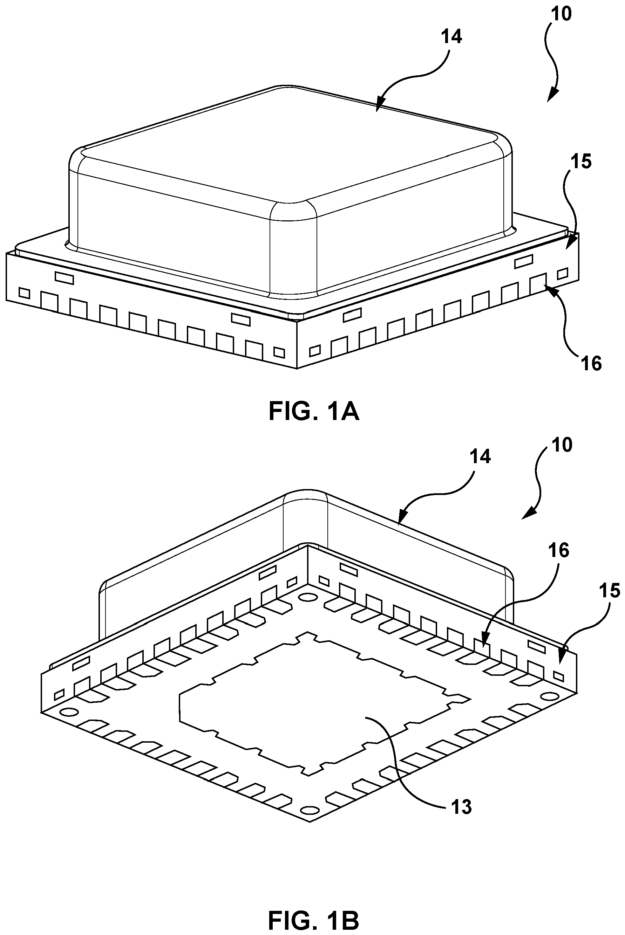

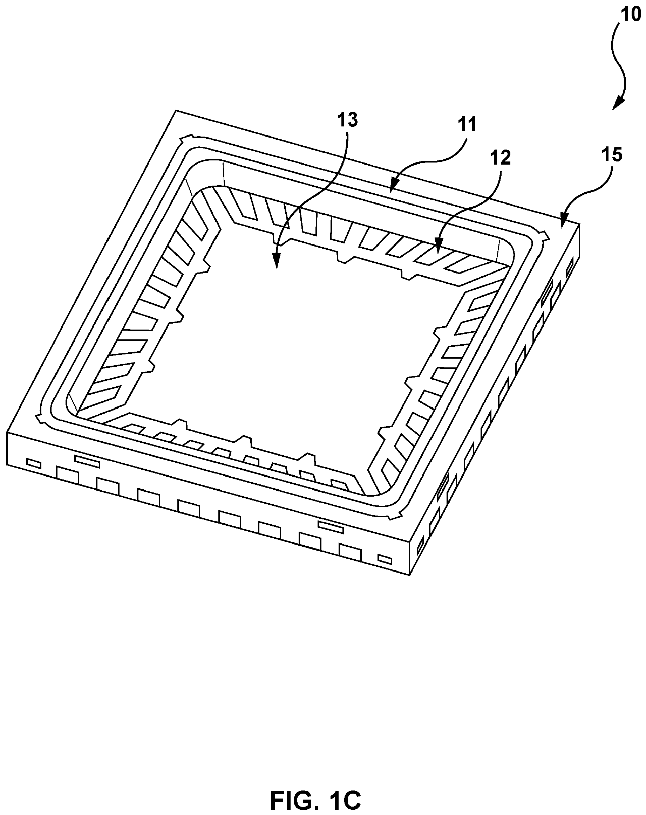

With reference to FIGS. 1A to 1C, a prior art cavity package 10 is shown with a pre-molded cavity leadframe, as illustrated in US Patents 9,257,370 and 9,536,812. Package 10 includes a metal seal ring 11, exposed lead fingers 12 for wire bonding, and a die attach pad (DAP) 13. As seen in FIG. 1C, the top sides of metal seal ring 11, lead fingers 12 and DAP 13 are all exposed (and can be seen when lid 14 (FIGS.1 A and 1B) is removed. As explained in patents 9,257,370 and 9,536,812, a molded plastic body 15 is formed onto the device. The bottom of the DAP 13 is seen in FIG. 1B. Element 16 is the leadframe that is molded within plastic body 15 to form the device.

As will be explained below, the present system employs manufacturing techniques and mechanical parts somewhat similar to those described in US Patents 9,257,370 and 9,536,812, and these patents are accordingly incorporated herein by reference in their entireties for all purposes. Importantly, however, the present system produces a novel and non-obvious Faraday cage which is not seen in US Patents 9,257,370 and 9,536,812.

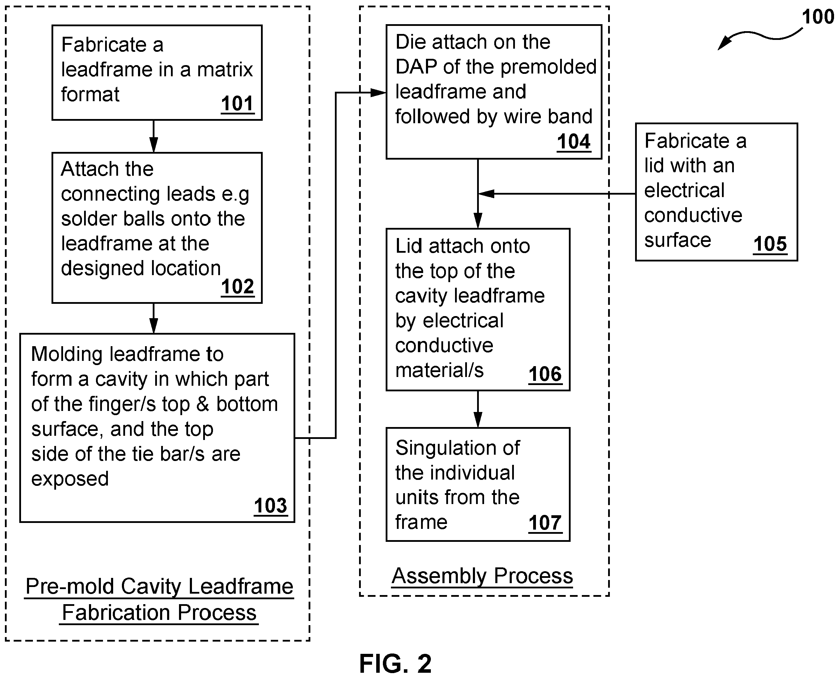

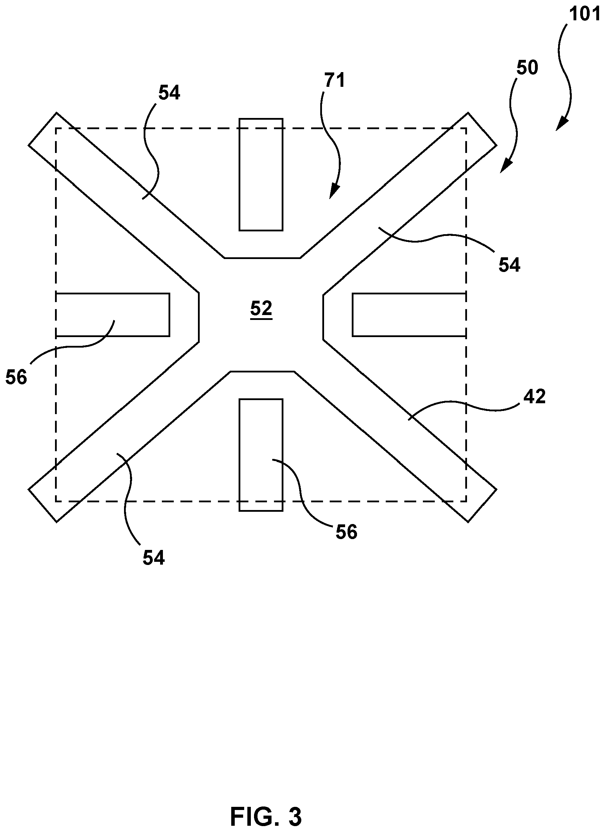

FIG. 2 is a flowchart showing steps in a first exemplary method 100 for constructing a Faraday cage plastic cavity package with a pre-molded cavity leadframe, as illustrated in FIGS. 3 to 8. Method 100 comprises the following steps:
a. Step 101- fabricate a leadframe 50 in a matrix format;
b. Step 102 - attach connecting leads (e.g. solder balls) 60 onto leadframe 50 at designed locations;
c. Step 103 - mold leadframe 50 with plastic (or other suitable material) to form a cavity 71 exposing the top and bottom surface of DAP 52, and exposing top portions of tie bars 54 and top and bottom portions of lead fingers 56;
d. Step 104 - attach a die onto DAP 52 by wire bonding;
e. Step 105 - fabricate a lid 90A or 90B or 90C with an electrical conductive bottom surface thereon;
f. Step 106 - attach lid 90A, or 90B or 90C onto the top of the cavity leadframe 50 by electrical conductive material/s; and
g. Step 107- use singulation (e.g.: saw singulation) to separate the individual devices 10 from the matrix.

As understood herein, a "matrix" format for manufacturing leadframes 50 is simply a repeating pattern of individual leadframes 50 all connected together. Further explanations of using a matrix to manufacture leadframes is set forth in US Patents 9,257,370 and 9,536,812 incorporated herein by reference in their entireties for all purposes.

FIG. 3 shows details at Step 101 of the process 100 set forth in FIG. 2 to fabricate a leadframe 50 in a matrix format (with only one leadframe 50 illustrated for clarity).

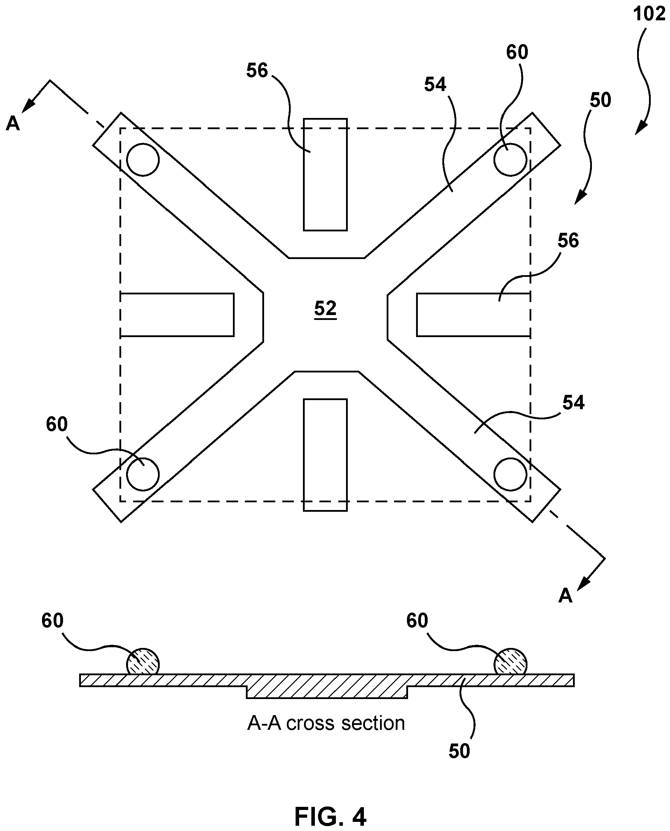

FIG. 4 shows details at Step 102 of the process 100 set forth in FIG. 2, including a cross-section through A-A. At this step, connecting leads 60 (e.g solder balls) are attached onto leadframe at their designed locations, as shown.

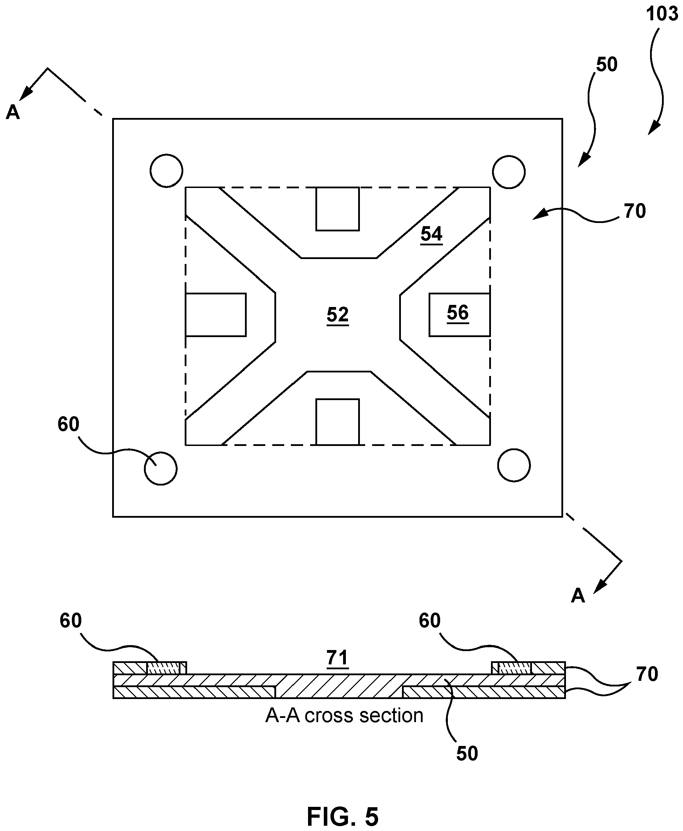

FIG. 5 shows details at Step 103 of the process 100 set forth in FIG. 2, including a cross-section through A-A, for molding a plastic body 70 onto leadframe 50 to form at least a cavity 71 in which part of fingers 56's top and bottom surfaces are exposed, the DAP 52's top and bottom surfaces are exposed, and the top side of tie bars 54 are exposed. As can also be seen, the tops of connecting leads (e.g.: solder balls) 60 are also exposed after the molding of plastic body 70 over leadframe 50.

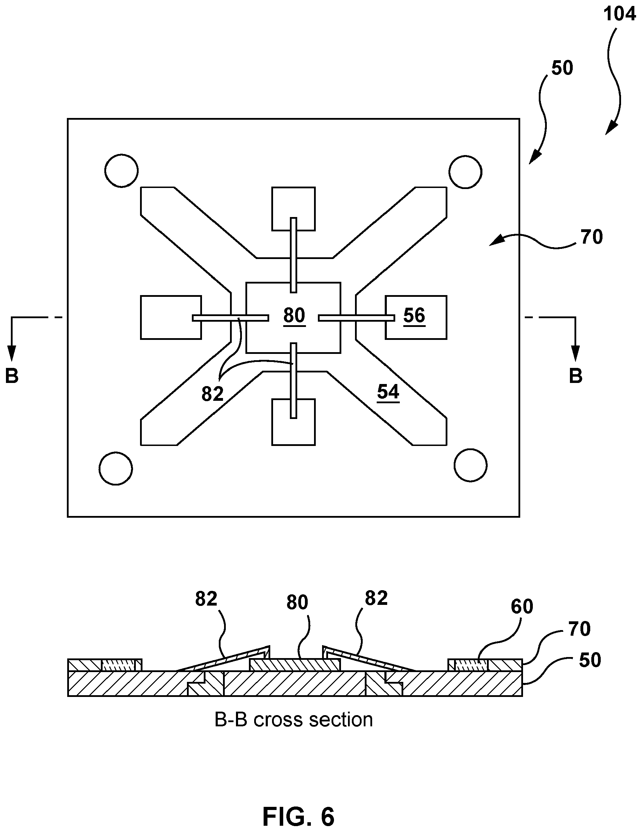

FIG. 6 shows details at Step 104 of the process 100 set forth in FIG. 2, including a cross-section through B-B, where die 80 is attached onto the top of DAP 52 with bonding wires 82 connected to fingers 56.

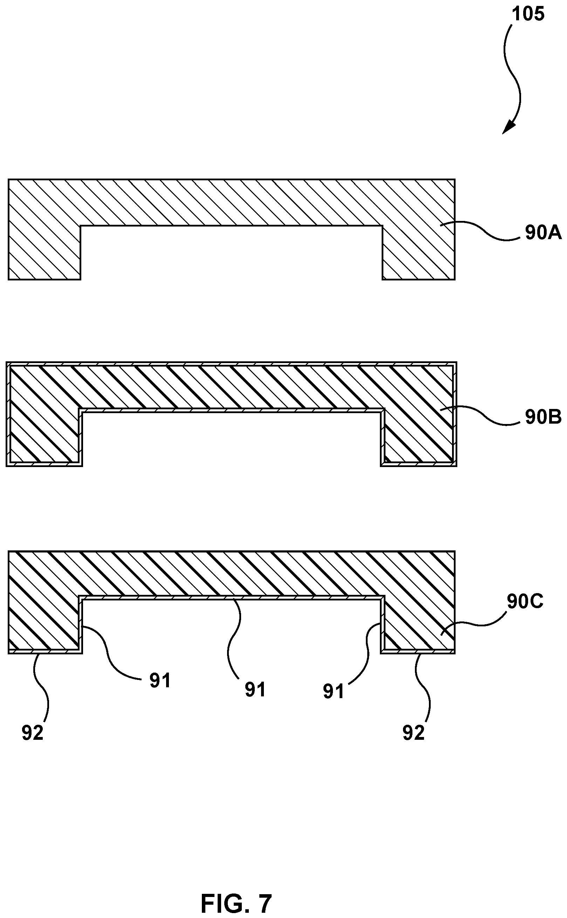

FIG. 7 shows details at Step 105 of the process 100 set forth in FIG. 2. in which a lid is fabricated. Lid 90A, or 90B or 90C is fabricated with an electrically conductive surface, and may be a metal lid 90A, a plastic lid 90B with electrical conducting coating on its entire surface, or a plastic lid 90C with electrical conducting coating only on its internal and bottom surfaces, 91 and 92 respectively.

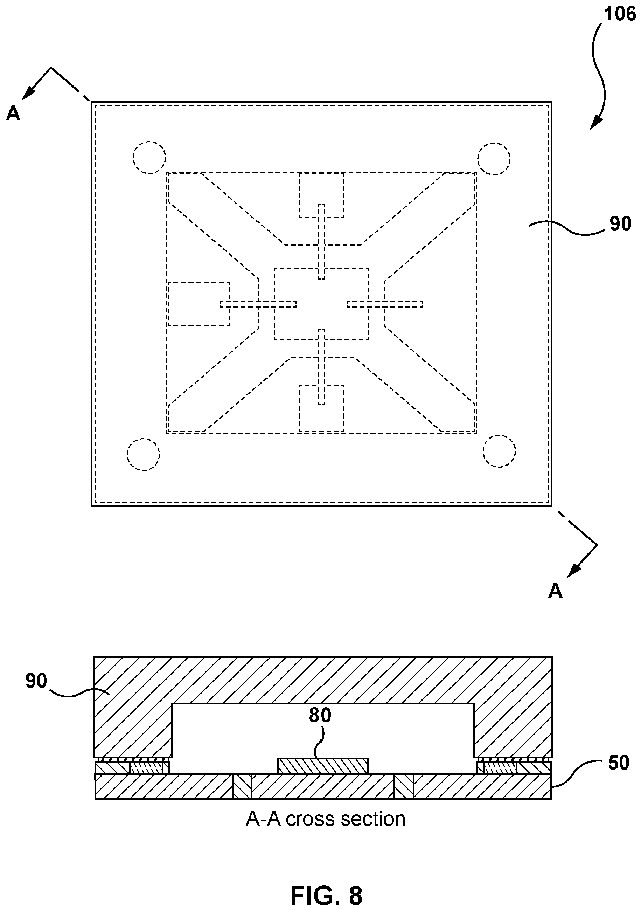

FIG. 8 shows details at Step 106 of the process 100 set forth in FIG. 2 in which lid 90 (90A, 90B or 90C) is attached onto the top of the cavity leadframe 50 by electrically conductive material/s.

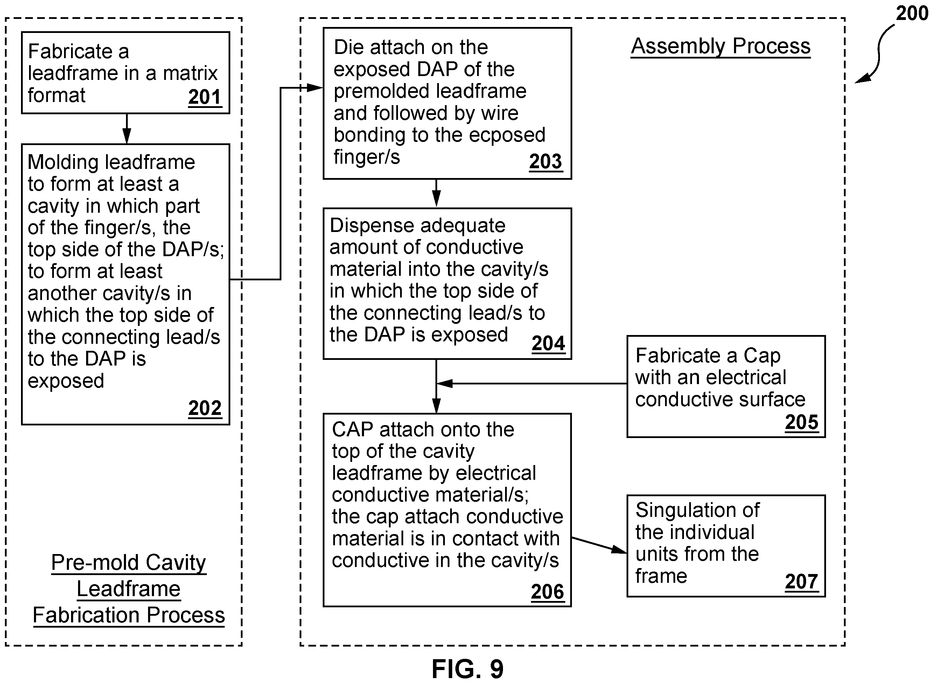

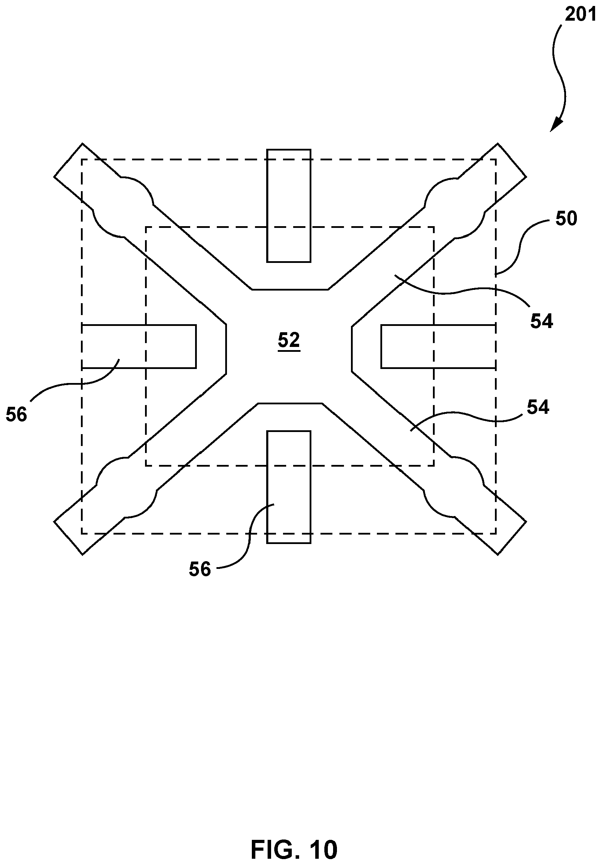

FIG. 9 is flowchart showing steps in a second exemplary method 200 for constructing a Faraday cage plastic cavity package with a pre-molded cavity leadframe, as illustrated in FIGS. 10 to 15. Method 200 comprises the following steps:
a. Step 201 - fabricate a leadframe in a matrix format;
b. Step 202 - plastic 70 is molded onto leadframe 50 to form at cavity 71 in which top portions of fingers 56 and the top side of DAP 52 are exposed. Secondary cavities 72 are also formed at the distal edges of tie bars 54, as shown;
c. Step 203 - a die 80 is attached on the exposed DAP 52 with wires 82 bonding to exposed fingers 65;
d. Step 204 - conductive materials are dispensed into secondary cavities 72 on top of the distal ends of tie bars 54;
e. Step 205 - fabricate a lid 90A or 90B or 90C with an electrical conductive bottom surface thereon;
f. Step 206 - attach lid 90A, or 90B or 90C onto the top of the cavity leadframe 50 by electrical conductive material/s, wherein the lid's electrically conductive material is in contact with conductive material in cavities 72; and
g. Step 207 - use singulation (e.g.: saw singulation) to separate the individual devices 10 from the matrix.

FIG. 10 shows details at Step 201 of the process 200 set forth in FIG. 9 to fabricate a leadframe in a matrix format (with only one leadframe 50 illustrated for clarity).

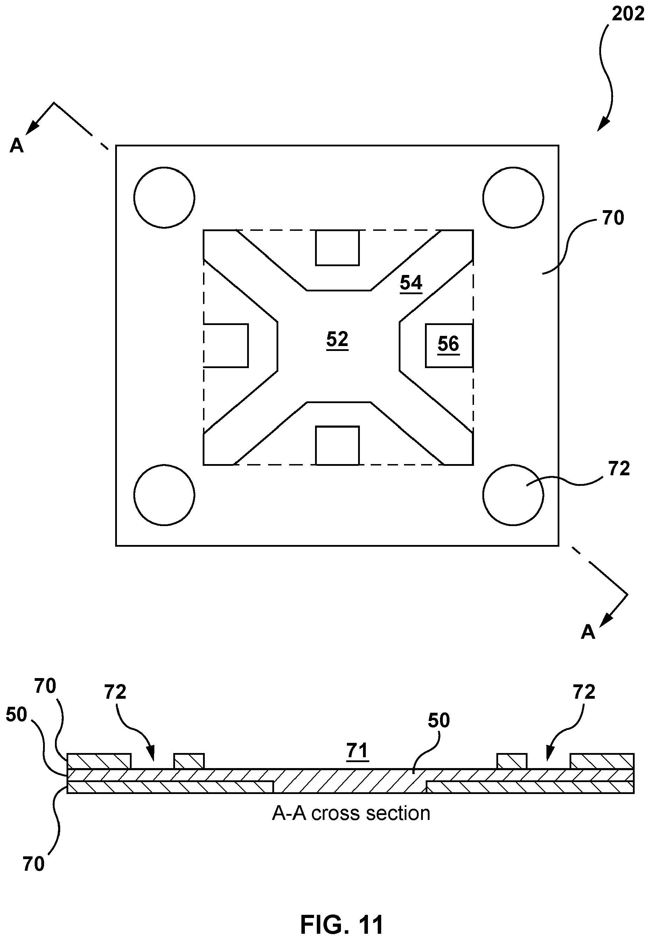

FIG. 11 shows details at Step 202 of the process 200 set forth in FIG. 9, including a cross section through A-A, for molding a plastic body 70 onto leadframe 50 to form at least a center cavity 71 in which part of fingers 56's top and bottom surfaces are exposed, and cavities 72 above the distal ends of tie bars 54 are also exposed. In center cavity 71, the DAP 52's top and bottom surfaces are exposed, and the top sides of the center portions of tie bars 54 are also exposed.

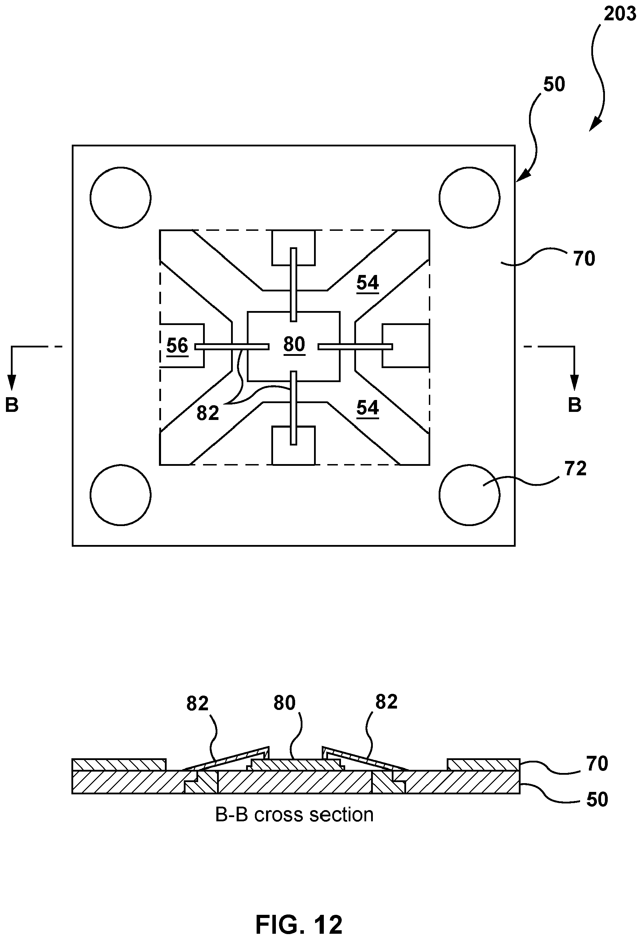

FIG. 12 shows details at Step 203 of the process 200 set forth in FIG. 9, including a cross-section through B-B, where die 80 is attached onto the top of DAP 52 with bonding wires 82 connected to fingers 56.

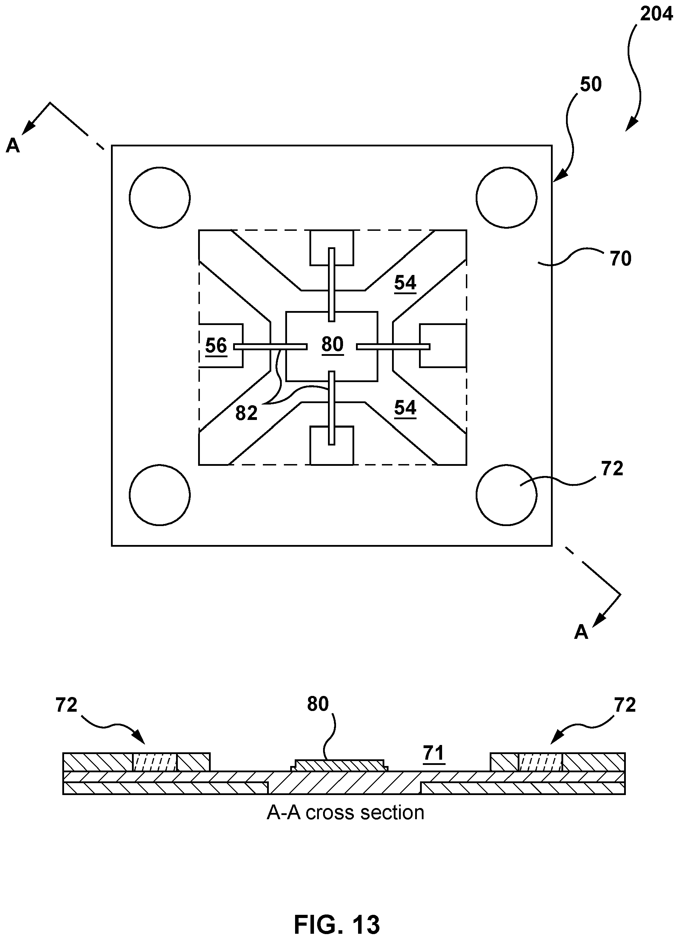

FIG. 13 shows details at Step 204 of the process 200 set forth in FIG. 9, including a cross-section through A-A, in which an adequate amount of conductive material is dispensed into cavities 72 in which the top side of the connecting lead/s to the DAP 52 are exposed.

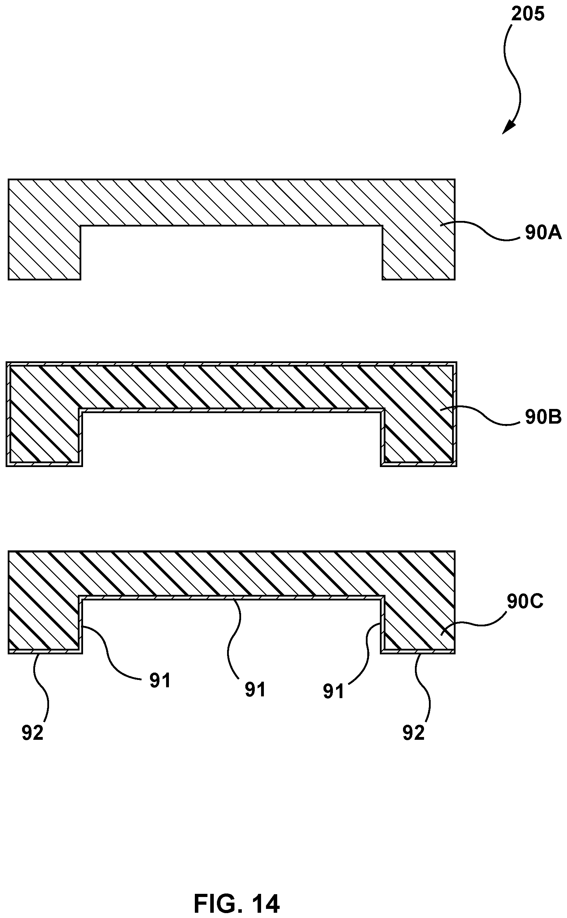

FIG. 14 shows details at Step 205 of the process 100 set forth in FIG. 2. in which a lid is fabricated. Lid 90A, or 90B or 90C is fabricated with an electrically conductive surface, and may be a metal lid 90A, a plastic lid 90B with electrical conducting coating on its entire surface, or a plastic lid 90C with electrical conducting coating only on its internal and bottom surfaces, 91 and 92 respectively.

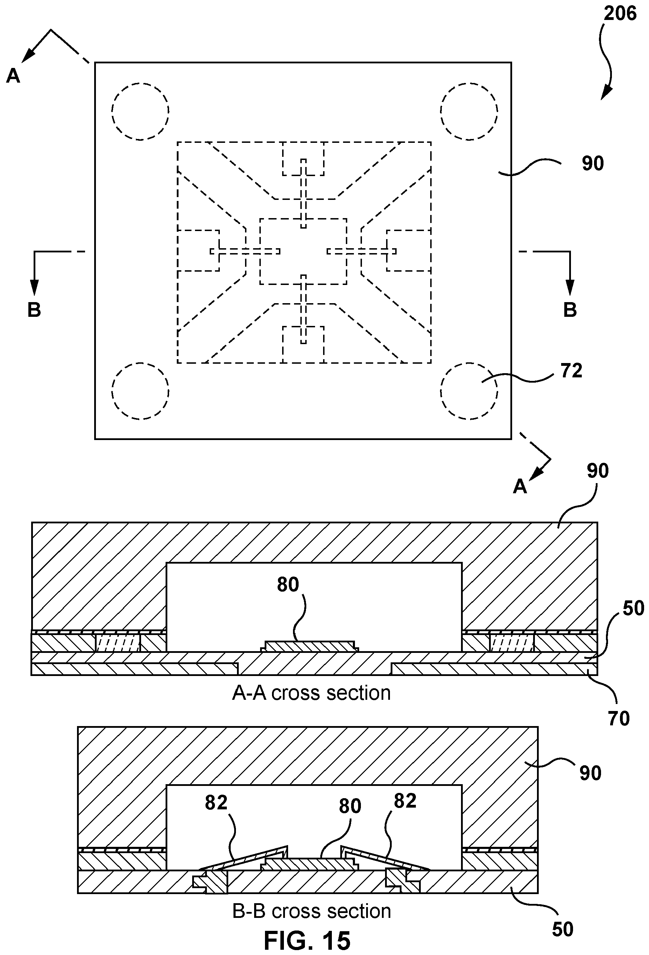

FIG. 15 shows details at Step 206 of the process 200 set forth in FIG. 9, including a cross-sections through A-A and B-B, showing details which lid 90 (90A, 90B or 90C) is attached onto the top of the cavity leadframe 50 by electrically conductive materials. Lid 90 may be connected to body 70 by electrically conductive adhesives.

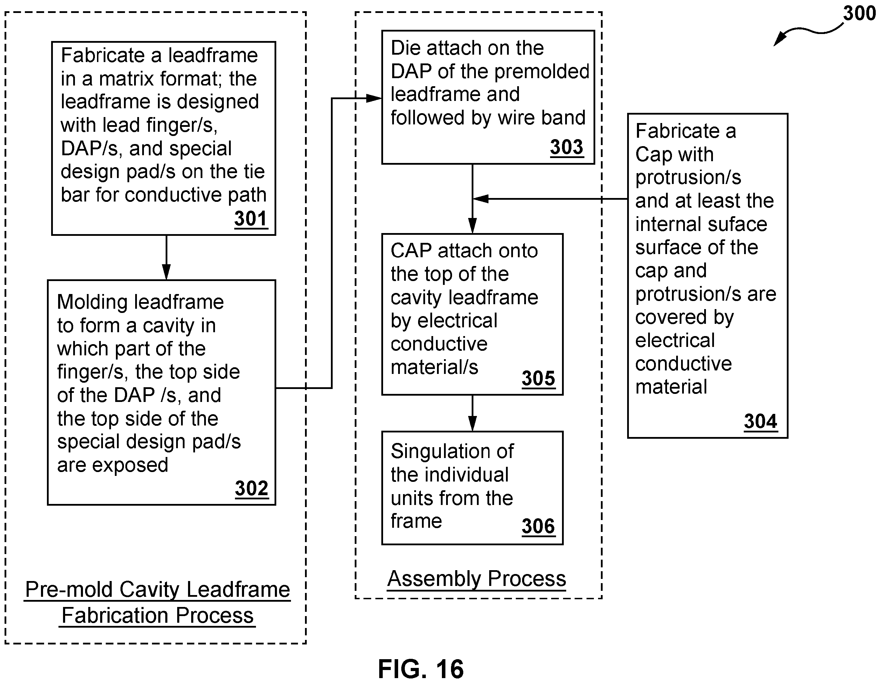

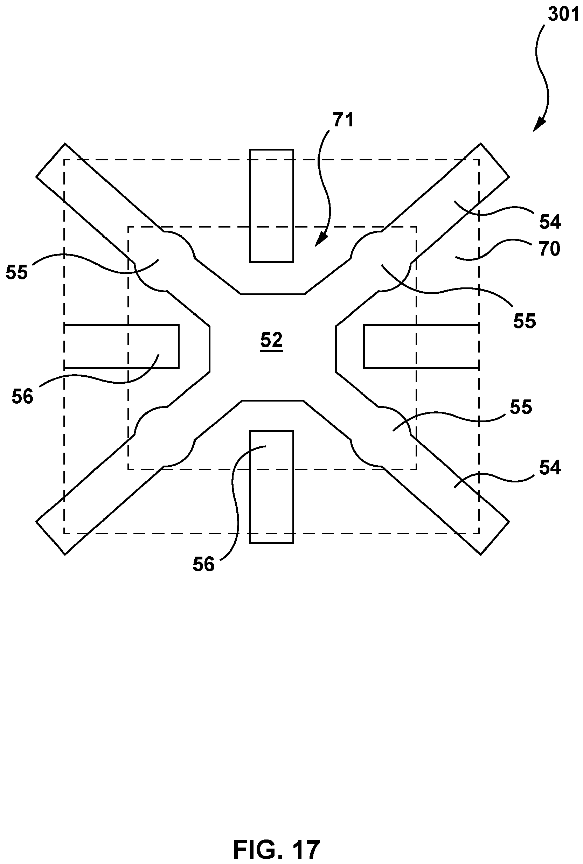

FIG. 16 is a flowchart showing steps in a third exemplary method 300 for constructing a Faraday cage plastic cavity package with a pre-molded cavity leadframe, as illustrated in FIGS. 17 to 21. Method 300 comprises the following steps:
a. Step 301- fabricate a leadframe in a matrix format;
b. Step 302 - plastic 70 is molded onto leadframe 50 to form at cavity 71 in which top portions of fingers 56 and the top side of DAP 52 are exposed, and the top sides of the special design pads 55 are also exposed, as shown.
c. Step 303 - a die 80 is attached on the exposed DAP 52 with wires 82 bonding to exposed fingers 65;
d. Step 304 - fabricate a lid 95A or 95B with an electrical conductive bottom protrusions 96 thereon;
e. Step 305 - attach lid 95A or 95B onto the top of the cavity leadframe 50 by electrical conductive material/s, wherein the lid's electrically conductive bottom protrusions 96 are in contact fingers 56; and
*f.* Step 306 - use singulation (e.g.: saw singulation) to separate the individual devices 10 from the matrix.

FIG. 17 shows details at Step 301 of the process 300 set forth in FIG. 16 to fabricate a leadframe in a matrix format (with only one leadframe 50 illustrated for clarity).

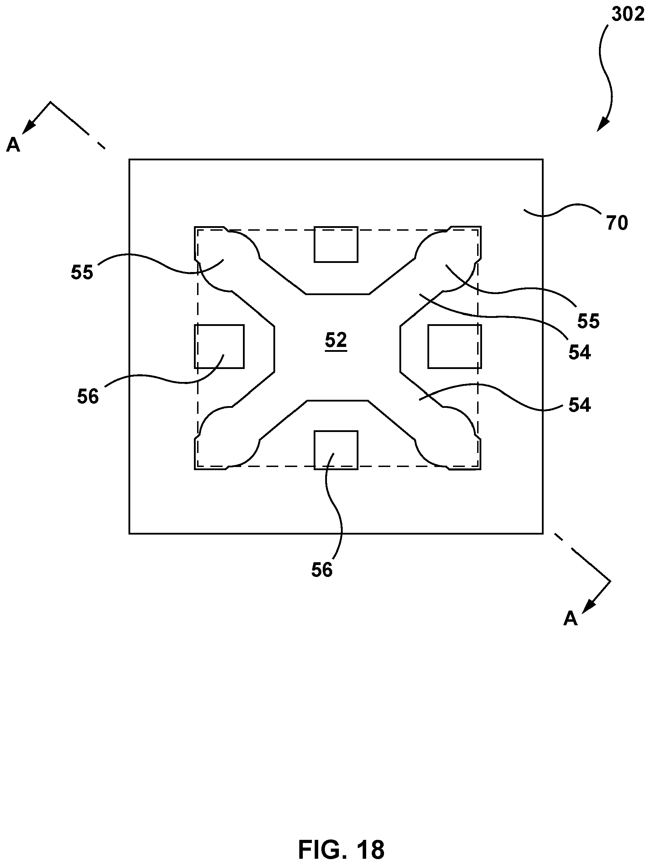

FIG. 18 shows details at Step 302 of the process 300 set forth in FIG. 16 for
molding a plastic body 70 onto leadframe 50 to form at least a center cavity 71 in which part of fingers 56's top and bottom surfaces are exposed, and design pads 55 on tie bars 54 are also exposed. In center cavity 71, the DAP 52's top and bottom surfaces are exposed, and the top sides of the center portions of tie bars 54 are also exposed.

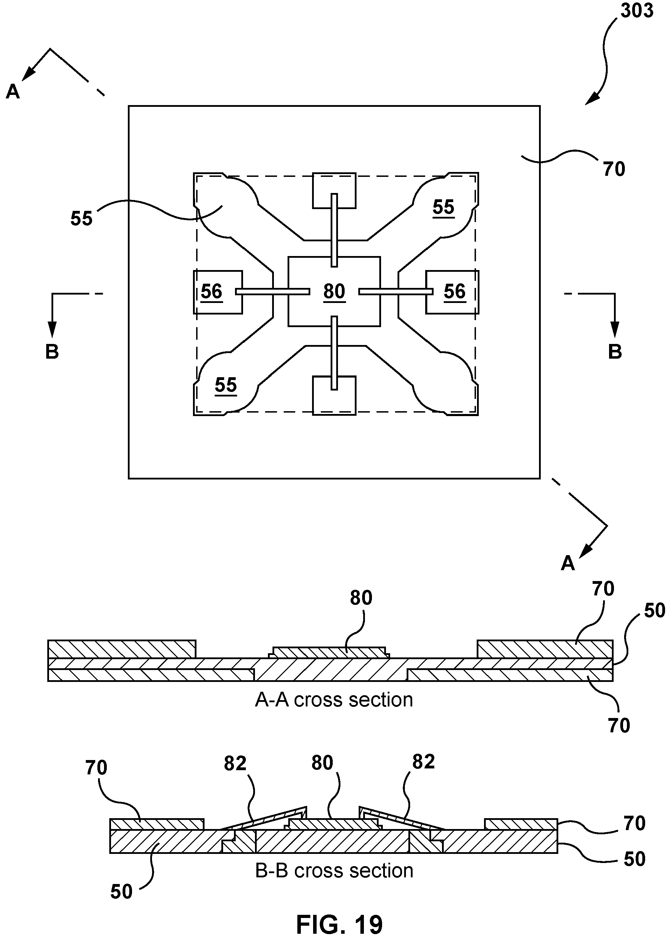

FIG. 19 shows details at Step 303 of the process 300 set forth in FIG. 16, including cross-sections through A-A and B-B, where die 80 is attached onto the top of DAP 52 with bonding wires 82 connected to fingers 56.

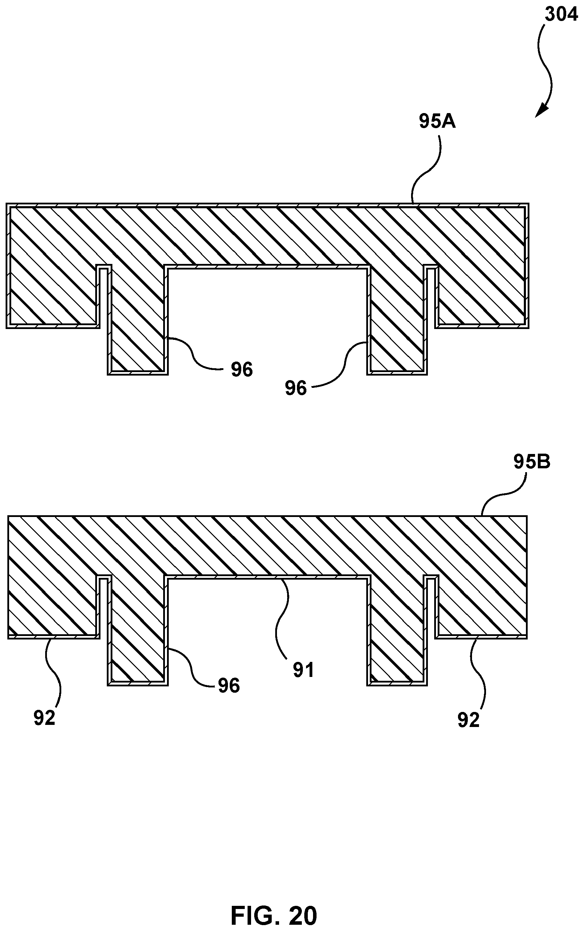

FIG. 20 shows details at Step 304 of the process 300 set forth in FIG. 16 to fabricate a lid 95A or 95B with bottom protrusions 96 thereon. Lid 95A or 95B is fabricated with an electrically conductive surface, and may be a metal lid 95A, or a plastic lid 95B with electrical conducting coating on its entire surface or its internal and bottom surfaces, 91 and 92 respectively.
wherein at least the internal surface surface of the cap and protrusion/s are covered by electrical conductive material, including option d) of a plastic lid with electrical conducted coating on its entire surface, or option e) of a plastic lid with electrical conducted coating on its internal & bottom surface.

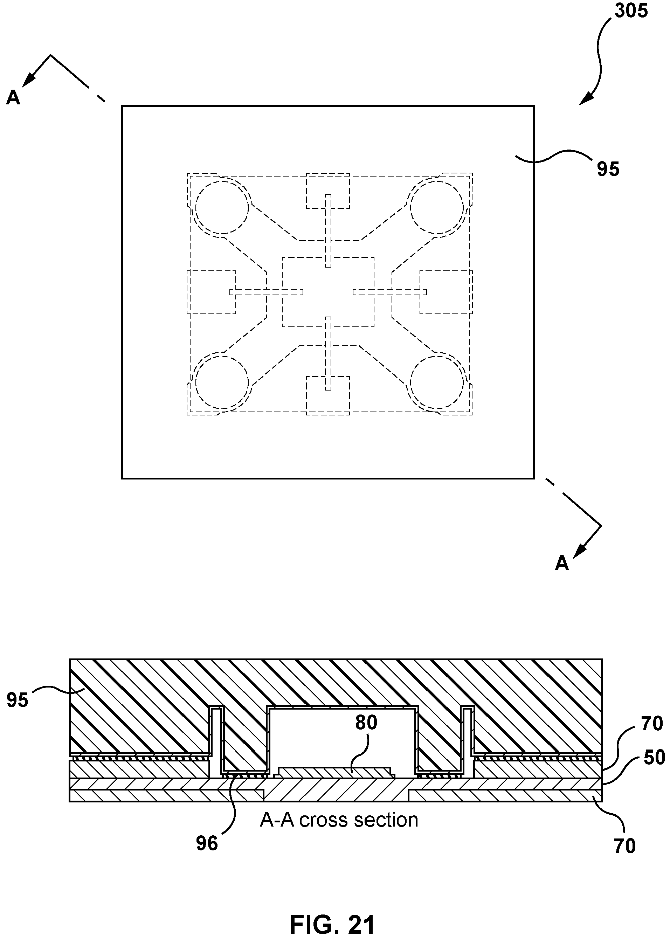

FIG. 21 shows details at Step 305 of the process 300 set forth in FIG. 16, including a cross-section through A-A, showing details which lid 95 (95A or 95B) is attached onto the top of the cavity leadframe 50 by electrically conductive materials. As can be seen, bottom protrusions 96 may be in electrical contact with fingers 96 while lid 95 may be connected to body 70 by electrically conductive adhesives.

In various preferred aspects, the present system further includes a method of manufacturing a Faraday cage cavity package, comprising: fabricating a matrix of leadframes 50, each leadframe 50 in the matrix having: a die attach paddle 52, tie bars 54 extending outwardly from die attach paddle 52, and lead fingers 56 positioned between tie bars 54; molding a (preferably plastic) body 70 onto the matrix of leadframes 50, wherein the molding the plastic comprises forming a cavity 71 in each leadframe 50 exposing portions of top surfaces of the die attach paddle 52, tie bars 54 and lead fingers 56 within the cavity; attaching a die 80 to die attach paddle 52 by wire bonding die 80 to lead fingers 56; attaching a lid 90 or 95 onto the top of each leadframe 50, the lid having an electrically conductive portion in electrical contact with tie bars 54; and then separating the matrix of leadframes into a plurality of individual Faraday cage cavity package units.

In preferred aspects, connecting leads 60 are attached onto tie bars 54 prior to molding the plastic body 70 onto the matrix of leadframes. In other preferred aspects, additional cavities 72 may be formed over the distal ends of tie bars 54. Cavities 72 may be filled with a conductive material, and then electrically connecting the lid 90 or 95 to the conductive material in cavities 72. In other preferred aspects, tie bars 54 have design pads 55 thereon, and design pads 55 are not covered by the molded plastic during the molding process. Design pads 55 can be disposed within cavity 71. Lid 90 or 95 has a bottom end portion with an electrically conductive coating thereon in contact with the design pads.

In preferred aspects, the bottom surfaces of die attach paddle 52 and lead fingers 54 are exposed and are soldered to an external circuit. Preferably, first portions of the bottom surfaces of the die attach paddle and the lead fingers are plated for surface mount reflow, and second portions of the bottom surfaces of the die attach paddle and the lead fingers are oxidized to resist solder wetting. In preferred embodiments, the leadframe 50 is made of metal and the molded body 70 is made of plastic.

While the forgoing exemplary embodiment is illustrative of the principles of the present invention, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

## Claims

1. A method of manufacturing a Faraday cage cavity package, comprising:
fabricating a matrix of leadframes, each leadframe in the matrix having:
a die attach paddle,
tie bars extending outwardly from the die attach paddle, and
lead fingers positioned between the tie bars;
molding plastic onto the matrix of leadframes, wherein the molding the plastic comprises forming a cavity in each leadframe exposing portions of top surfaces of the die attach paddle, the tie bars and the lead fingers within the cavity;
attaching a die to the die attach paddle on each leadframe by wire bonding the die to the lead fingers;
attaching a lid onto the top of each leadframe, the lid having an electrically conductive portion in electrical contact with the tie bars; and then
separating the matrix of leadframes into a plurality of individual Faraday cage cavity package units.

2. The method of claim 1, further comprising:
attaching connecting leads onto the tie bars prior to molding the plastic onto the matrix of leadframes, wherein the plastic is not molded over the connecting leads.

3. The method of claim 1, wherein molding plastic onto the matrix of leadframes further comprises forming additional cavities over distal ends of the tie bars, further comprising:
filling the additional cavities with a conductive material, and then electrically connecting the lid to the conductive material in the additional cavities.

4. The method of claim 1, wherein the tie bars have design pads thereon, wherein the design pads are not covered by the molded plastic, and wherein the lid comprises a bottom end portion with an electrically conductive coating thereon in contact with the design pads.

5. The method of claim 1, wherein attaching the lid further comprises applying an electrically conductive coating to a plastic lid prior to attaching the plastic lid onto the leadframe.

6. The method of claim 1, wherein molding plastic onto the matrix of leadframes further comprises exposing portions of bottom surfaces of the die attach paddle and the lead fingers.

7. The method of claim 1, further comprising:
plating first portions of the bottom surfaces of the die attach paddle and the lead fingers for surface mount reflow, and
oxidizing second portions of the bottom surfaces of the die attach paddle and the lead fingers to resist solder wetting.

8. The method of claim 1, wherein separating the matrix of leadframes into a plurality of individual Faraday cage cavity package units comprises saw singulation.

9. A Faraday cage cavity package, comprising:
a leadframe having:
a die attach paddle,
tie bars extending outwardly from the die attach paddle, and
lead fingers positioned between the tie bars;
a body molded to the leadframe forming a cavity exposing top surfaces of the die attach paddle, the tie bars and the lead fingers within the cavity;
a die attached to the die attach pad by wire bonding to the lead fingers; and a lid attached onto the top of the leadframe, the lid having an electrically conductive portion in electrical contact with the tie bars.

10. The Faraday cage cavity package of claim 9, further comprising:
connecting leads attached onto the tie bars, wherein the body is not molded over the connecting leads.

11. The Faraday cage cavity package of claim 9, further comprising:
additional cavities over distal ends of the tie bars, wherein the additional cavities are filled with conductive materials.

12. The Faraday cage cavity package of claim 9, wherein the tie bars have design pads thereon and wherein the lid comprises a bottom end portion with an electrically conductive coating thereon in contact with the design pads on the tie bars.

13. The Faraday cage cavity package of claim 12, wherein the design pads are disposed within the cavity.

14. The Faraday cage cavity package of claim 9, wherein the lid is one of:
a metal lid, or
a plastic lid with an electrically conductive coating.

15. The Faraday cage cavity package of claim 9, wherein:
first portions of the bottom surfaces of the die attach paddle and the lead fingers are plated for surface mount reflow, and
second portions of the bottom surfaces of the die attach paddle and the lead fingers are oxidized to resist solder wetting.
